# EUROPEAN PATENT APPLICATION

(11) **EP 4 300 605 A1**
(43) Date of publication of application: **03.01.2024**
(21) Application number: 22759721.8
(22) Date of filing: 24.02.2022
(51) Int. Cl.: H01L 33/12, H01L 21/20, H01L 21/205, C23C 16/04, C23C 16/34

(54) **SEMICONDUCTOR SUBSTRATE, METHOD FOR PRODUCING SAME, APPARATUS FOR PRODUCING SAME, AND TEMPLATE SUBSTRATE**

(30) Priority: 26.02.2021 JP 2021031036
(71) Applicant: Kyocera Corporation, Kyoto-shi Kyoto 612-8501 (JP)
(72) Inventor: MASAKI, Katsuaki, Kyoto-shi, Kyoto 612-8501 (JP); KAMIKAWA, Takeshi, Kyoto-shi, Kyoto 612-8501 (JP); KOBAYASHI, Toshihiro, Kyoto-shi, Kyoto 612-8501 (JP); HAYASHI, Yuichiro, Kyoto-shi, Kyoto 612-8501 (JP); AOKI, Yuta, Kyoto-shi, Kyoto 612-8501 (JP)
(74) Representative: Viering, Jentschura & Partner mbB Patent- und Rechtsanwälte
(86) International application number: PCT/JP2022/007587
(87) International publication number: WO 2022/181686

(57) **Abstract**

A semiconductor substrate includes a support substrate (1), a mask pattern (6) located above the support substrate and including a mask portion (5), a seed portion (4) locally located in a layer above the support substrate in a plan view, and a semiconductor part (8) including a GaN-based semiconductor and located above the mask pattern (6) to be in contact with the seed portion (4) and the mask portion (5).

## Description

### TECHNICAL FIELD

The present invention relates to a semiconductor substrate and the like.

### BACKGROUND OF INVENTION

For example, Patent Literature 1 discloses a method for forming a mask pattern on a base substrate including a GaN layer (seed layer) and forming a semiconductor part on the mask pattern by using an epitaxial lateral overgrowth (ELO) method.

### CITATION LIST

### PATENT LITERATURE

Patent Document 1: JP 2011-66390 A

### SUMMARY

A semiconductor substrate according to the present disclosure includes a support substrate, a mask pattern located in a layer above the support substrate and comprising a mask portion, a seed portion locally located in a layer above the support substrate in a plan view, and a semiconductor part including a GaN-based semiconductor and disposed in a layer above the mask pattern in a manner that the semiconductor part is in contact with the seed portion and the mask portion.

### BRIEF DESCRIPTION OF THE DRAWINGS

FIG. 1 includes a plan view and a cross-sectional view illustrating a configuration of a semiconductor substrate according to the present embodiment.
FIG. 2 is a plan view illustrating another configuration of the semiconductor substrate according to the present embodiment.
FIG. 3 is a plan view illustrating another configuration of the semiconductor substrate according to the present embodiment.
FIG. 4 is a cross-sectional view illustrating another configuration of the semiconductor substrate according to the present embodiment.
FIG. 5 is a cross-sectional view illustrating another configuration of the semiconductor substrate according to the present embodiment.
FIG. 6 is a cross-sectional view illustrating another configuration of the semiconductor substrate according to the present embodiment.
FIG. 7 is a flowchart illustrating an example of a method for manufacturing the semiconductor substrate according to the present embodiment.
FIG. 8 is a block diagram illustrating an example of an apparatus for manufacturing the semiconductor substrate according to the present embodiment.
FIG. 9 is a flowchart illustrating an example of a method for manufacturing a semiconductor device according to the present embodiment.
FIG. 10 is a plan view illustrating an example of isolation of an element portion.
FIG. 11 is a cross-sectional view illustrating an example of isolation and separation of the element portion.
FIG. 12 is a schematic view illustrating a configuration of an electronic device according to the present embodiment.
FIG. 13 is a schematic view illustrating another configuration of the electronic device according to the present embodiment.
FIG. 14 is a cross-sectional view illustrating a configuration of the semiconductor substrate according to Example 1.
FIG. 15A is a cross-sectional view illustrating a configuration of a template substrate according to Example 1.
FIG. 15B is an enlarged view illustrating the configuration of the template substrate according to Example 1.
FIG. 16 is a cross-sectional view illustrating an application example of the template substrate.
FIG. 17A is a flowchart illustrating a method for manufacturing the semiconductor substrate of Example 1.
FIG. 17B is a cross-sectional view illustrating the method for manufacturing the semiconductor substrate of Example 1.
FIG. 18A is a flowchart illustrating a method for manufacturing the semiconductor substrate of Example 1.
FIG. 18B is a cross-sectional view illustrating the method for manufacturing the semiconductor substrate of Example 1.
FIG. 19 is a cross-sectional view illustrating an example of lateral growth of a semiconductor part.
FIG. 20 is a cross-sectional view illustrating a step of separating the element portion in Example 1.
FIG. 21 is a cross-sectional view illustrating another configuration of the semiconductor substrate of Example 1.
FIG. 22 is a cross-sectional view illustrating another configuration of the semiconductor substrate of Example 1.
FIG. 23 is a cross-sectional view illustrating another configuration of the semiconductor substrate of Example 1.
FIG. 24 is a cross-sectional view illustrating a step of isolating the element portion in Example 1.
FIG. 25 is a cross-sectional view illustrating another configuration of the semiconductor substrate of Example 1.
FIG. 26 is a cross-sectional view illustrating another configuration of the semiconductor substrate of Example 1.
FIG. 27 is a cross-sectional view illustrating another configuration of the semiconductor substrate of Example 1.
FIG. 28 is a cross-sectional view illustrating a configuration of the semiconductor substrate of Example 2.
FIG. 29 is a cross-sectional view illustrating another configuration of the semiconductor substrate of Example 2.
FIG. 30 is a cross-sectional view illustrating a configuration of the semiconductor substrate of Example 3.
FIG. 31 is a cross-sectional view illustrating a configuration of the semiconductor substrate of Example 4.
FIG. 32 is a cross-sectional view illustrating another configuration of the semiconductor substrate of Example 4.
FIG. 33 is a schematic cross-sectional view illustrating a configuration of Example 6.
FIG. 34 is a cross-sectional view illustrating an application example to an electronic device of Example 6.
FIG. 35 is a schematic cross-sectional view illustrating a configuration of Example 7.

### DESCRIPTION OF EMBODIMENTS

### Semiconductor Substrate

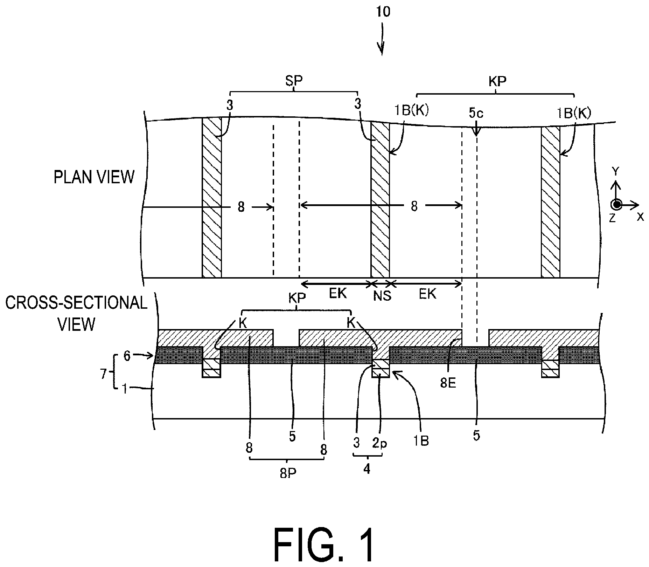

FIG. 1 is a plan view and a cross-sectional view illustrating a configuration of a semiconductor substrate according to the present embodiment. As illustrated in FIG. 1, a semiconductor substrate 10 (semiconductor wafer) according to the present embodiment includes a support substrate 1 (main substrate 1), a mask pattern 6 located in a layer above the support substrate 1 and having a mask portion 5, a seed portion 3 locally located in a layer above the support substrate 1 in the plan view, and a semiconductor part 8 including a GaN-based semiconductor and located in a layer above the mask pattern 6 to be in contact with the seed portion 3 and the mask portion 5. The term "locally located" means "not being entirely disposed above the support substrate 1", and can be rephrased as "partially located" or "non-entirely located". In FIG. 1, a buffer portion 2p locally located in the plan view is provided between the support substrate 1 and the seed portion 3, and hereinafter, the seed portion 3 and the buffer portion 2p may be collectively referred to as a laminate 4. The mask pattern 6 may be a layered mask layer 6. A seed pattern SP may include the seed portion 3, and a semiconductor pattern 8P may include the semiconductor part 8.

The mask pattern 6 has an opening K, and the seed portion 3 and the buffer portion 2p are locally disposed to overlap the opening K in the plan view. An opening pattern KP of the mask pattern 6 may include the opening K. The opening K has a longitudinal shape in which a first direction (X direction) is a width direction and a second direction (Y direction) is a longitudinal direction, and the seed portion 3 and the buffer portion 2p each have a longitudinal shape. The semiconductor part 8 has an edge 8E located between a mask portion center 5c and the seed portion 3 in the plan view. The opening K may have a tapered shape (shape that narrows downward).

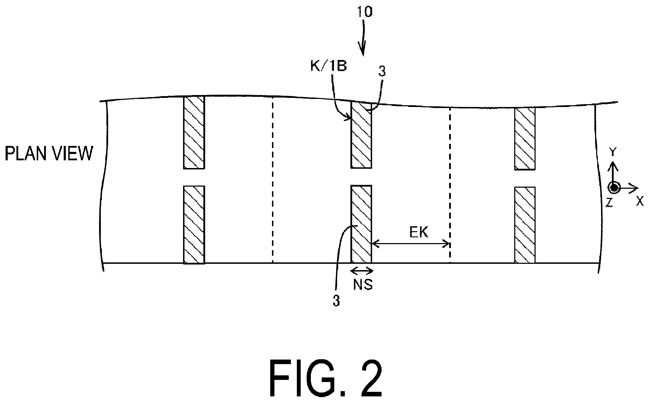

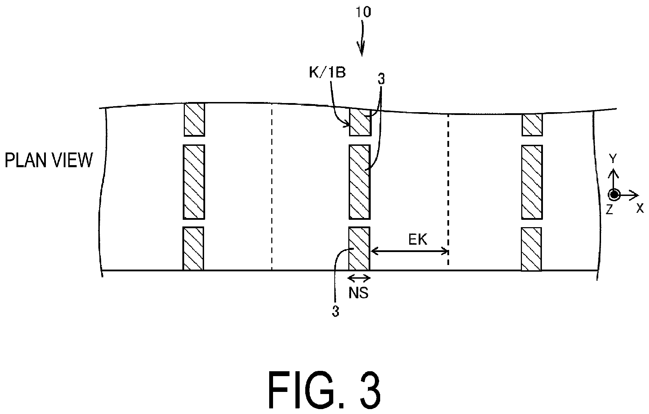

FIGs. 2 and 3 are plan views other configurations of the semiconductor substrate according to the present embodiment. As illustrated in FIG. 2, the openings K may be periodically divided in the longitudinal direction (Y direction). As illustrated in FIG. 3, the opening K may have a polygon shape such as a square. By dividing the opening K in the longitudinal direction, the semiconductor part 8 grown on the opening K is also divided, so that warp caused by a difference in thermal expansion coefficient between the semiconductor part 8 and the support substrate 1 in the longitudinal direction (Y direction) can be reduced.

In the semiconductor substrate 10, a plurality of layers are layered on the support substrate 1, and the layering direction thereof can be defined as an "upward direction". Viewing an object with a line of sight parallel to a normal direction of the semiconductor substrate 10 can be referred to as "plan view". The semiconductor substrate refers to a substrate including a semiconductor part and the support substrate 1 may be a semiconductor or a non-semiconductor.

The support substrate 1, the buffer portion 2p, the seed portion 3, and the mask pattern 6 may be collectively referred to as a template substrate 7.

The semiconductor part 8 includes, for example, a nitride semiconductor (for example, a GaN-based semiconductor). A nitride semiconductor may be expressed, for example, by AlxGayInzN (0 ≤ x ≤ 1; 0 ≤ Y ≤ 1; 0 ≤ Z ≤ 1; X + Y + Z = 1). Specific examples may include a GaN-based semiconductor, aluminum nitride (AlN), indium aluminum nitride (InAlN), and indium nitride (InN). The GaN-based semiconductor is a semiconductor including gallium atoms (Ga) and nitrogen atoms (N), and examples thereof include GaN, AlGaN, AlGaInN, and InGaN. The semiconductor part 8 may be of a doped type (for example, n-type including a donor) or a non-doped type.

The semiconductor part 8 including the GaN-based semiconductor can be formed by an epitaxial lateral overgrowth (ELO) method. In the ELO method, for example, a heterogeneous substrate having a lattice constant different from that of the GaN-based semiconductor is used as the support substrate 1, the seed portion 3 including the GaN-based semiconductor is used, an inorganic compound film is used for the mask pattern 6, and the GaN-based semiconductor part 8 can be laterally grown on the mask portion 5. In this case, the thickness direction (Z direction) of the semiconductor part 8 can be the <0001> direction (c-axis direction) of a GaN-based crystal, the width direction (X direction) of the opening K having a longitudinal shape can be the <11-20> direction (a-axis direction) of the GaN-based crystal, and the longitudinal direction (Y direction) of the opening K can be the <1-100> direction (m-axis direction) of the GaN-based crystal. A layer (including the semiconductor part 8) formed by the ELO method may be referred to as an ELO semiconductor part.

The ELO semiconductor part 8 includes a low defect portion (dislocation non-inheritance portion) EK overlapping the mask portion 5 in the plan view and having relatively few threading dislocations, and a dislocation inheritance portion NS overlapping the opening K in the plan view and having relatively many threading dislocations. When a layer above the semiconductor part 8 includes an active layer (for example, a layer in which electrons and holes are combined), the active layer can be provided to overlap the low defect portion EK in the plan view.

The low defect portion EK can be configured such that a non-threading dislocation density in a cross section parallel to the <0001> direction is greater than a threading dislocation density in an upper surface. The threading dislocation is a dislocation (defect) extending from the lower surface or inside of the semiconductor part 8 to the surface or surface layer thereof along the thickness direction (Z direction) of the semiconductor part 8. The threading dislocation can be observed by performing cathode luminescence (CL) measurement on the surface (parallel to a c-plane) of the semiconductor part 8. The non-threading dislocation is a dislocation measured by CL in a cross section taken along a plane parallel to the thickness direction, and is mainly a basal plane (c-plane) dislocation.

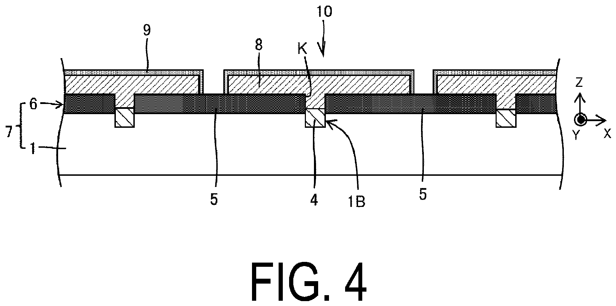

FIG. 4 is a cross-sectional view illustrating another configuration of the semiconductor substrate according to the present embodiment. As illustrated in FIG. 4, the semiconductor substrate 10 includes the support substrate 1, the laminate 4 (a buffer portion and a seed portion), the mask pattern 6, the semiconductor part 8, and a functional layer 9 located above the semiconductor part 8. The functional layer 9 may be, for example, a compound semiconductor part including a nitride semiconductor, or may be a single layer or multiple layers.

The functional layer 9 may have at least one of a function as a constituent element of a semiconductor device, a function of protecting from external force, a function of protecting from static electricity, a protection function of suppressing entry of foreign matter such as water and oxygen, a function of protecting from an etchant or the like, an optical function, and a sensing function.

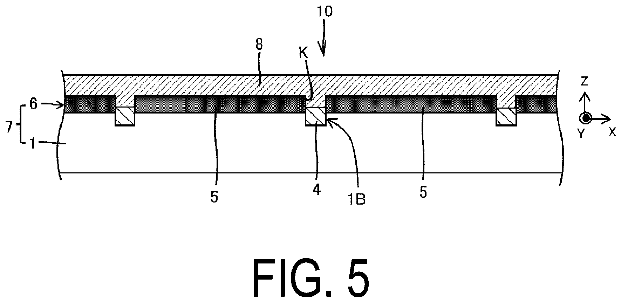

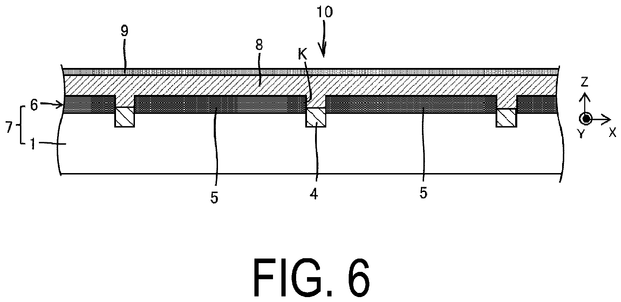

FIG. 5 is a cross-sectional view illustrating another configuration of the semiconductor substrate according to the present embodiment. In FIG. 1, the semiconductor part 8 has the edge 8E located on the mask portion 5; however, the present disclosure is not limited thereto. As illustrated in FIG. 5, semiconductor films laterally grown in opposite directions from adjacent openings K may be associated with each other so that the semiconductor part 8 has no edge on the mask portion 5 (association type). FIG. 6 is a cross-sectional view illustrating another configuration of the semiconductor substrate according to the present embodiment. As illustrated in FIG. 6, the functional layer 9 can be provided in a layer above the association type semiconductor part 8.

### Manufacturing of Semiconductor Substrate

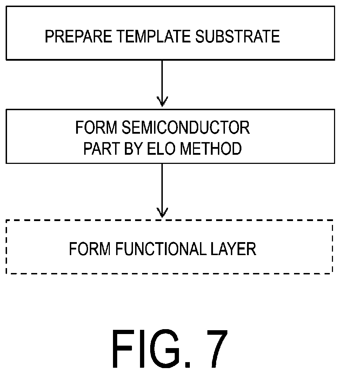

FIG. 7 is a flowchart illustrating an example of a method for manufacturing the semiconductor substrate according to the present embodiment. In the method for manufacturing the semiconductor substrate in FIG. 7, after a step of preparing the template substrate 7, a step of forming the semiconductor part 8 on the template substrate 7 by using the ELO method is performed. After the step of forming the semiconductor part 8, a step of forming the functional layer 9 can be performed as necessary.

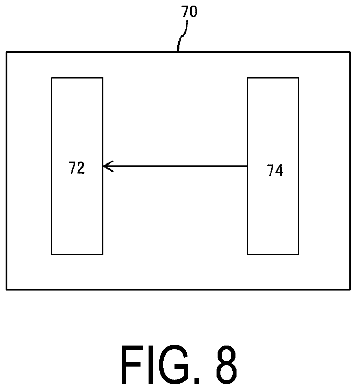

FIG. 8 is a block diagram illustrating an example of an apparatus for manufacturing the semiconductor substrate according to the present embodiment. An apparatus 70 for manufacturing the semiconductor substrate in FIG. 8 includes a semiconductor former 72 configured to form the semiconductor part 8 on the template substrate 7 and a controller 74 configured to control the semiconductor former 72. The semiconductor former 72 forms the semiconductor part 8 (see FIG. 1) including the GaN-based semiconductor by the ELO method so as to be in contact with the local seed portion 3 and the mask portion 5. The apparatus 70 for manufacturing the semiconductor substrate may be configured to form the functional layer 9.

The semiconductor former 72 may include an MOCVD device, and the controller 74 may include a processor and a memory. The controller 74 may be configured to control the semiconductor former 72 by executing a program stored in a built-in memory, a communicable communication device, or an accessible network, for example, and the present embodiment also includes the program, and a recording medium storing the program therein.

### Manufacturing of Semiconductor Device

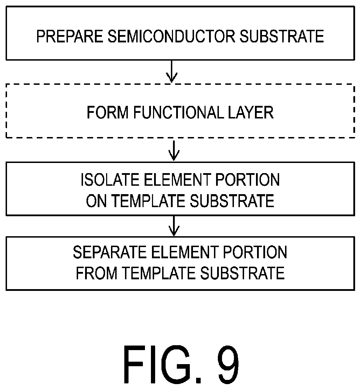

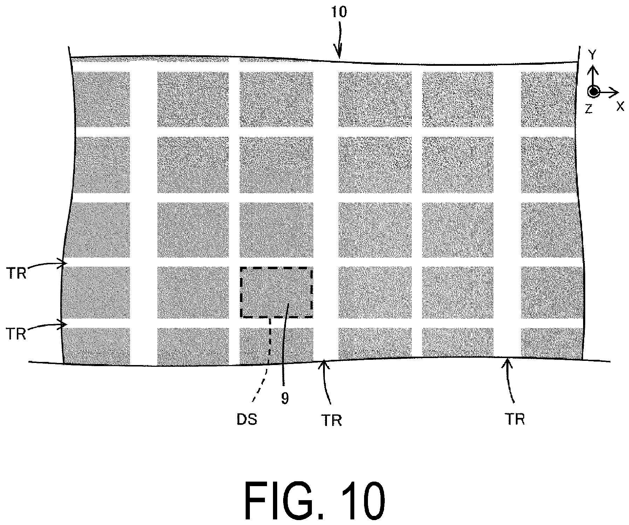

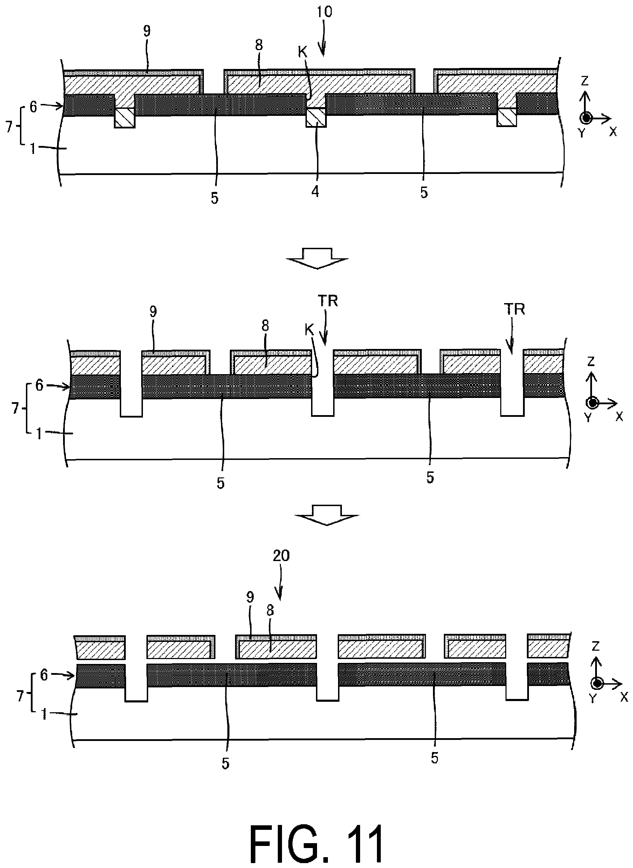

FIG. 9 is a flowchart illustrating an example of a method for manufacturing a semiconductor device according to the present embodiment. FIG. 10 is a plan view illustrating an example of isolation of an element portion. FIG. 11 is a cross-sectional view illustrating an example of isolation and separation of the element portion. In the method for manufacturing the semiconductor device in FIG. 9, after a step of preparing the semiconductor substrate 10, a step of forming the functional layer 9 on the semiconductor part 8 is performed as necessary. Subsequently, as illustrated in FIGs. 10 and 11, a step of forming a plurality of trenches TR (isolation trenches) in the semiconductor substrate 10 to isolate an element portion DS (including the low defect portion EK of the semiconductor part 8 and the functional layer 9) is performed. The trench TR passes through the functional layer 9 and the semiconductor part 8.

The mask portion 5 and the support substrate 1 may be exposed in the trench TR. An opening width of the trench TR may be equal to or greater than the width of the opening K. At this stage, the element portion DS is Van der Waals-coupled to the mask portion 5, and is a part of the semiconductor substrate 10. Subsequently, as illustrated in FIG. 11, a step of separating the element portion DS from the template substrate 7 to form a semiconductor device 20 is performed. The step of preparing semiconductor substrate 10 in FIG. 9 may include each step of the method for manufacturing the semiconductor substrate illustrated in FIG. 7.

### Semiconductor Device

As illustrated in FIG. 11, by separating the element portion DS from the template substrate 7, the semiconductor device 20 (including the semiconductor part 8) can be formed. Specific examples of the semiconductor device 20 include light emitting diodes (LEDs), semiconductor lasers, Schottky diodes, photodiodes, and transistors (including a power transistor and a high electron mobility transistor).

### Electronic Device

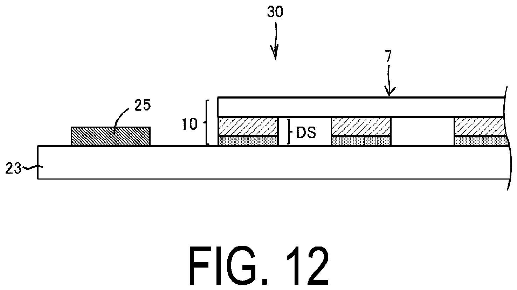

FIG. 12 is a schematic view illustrating a configuration of an electronic device according to the present embodiment. An electronic device 30 in FIG. 12 includes the semiconductor substrate 10 (configuration serving as a semiconductor device while including the template substrate 7, for example, when the template substrate 7 is light-transmissive), a drive substrate 23 on which the semiconductor substrate 10 is mounted, and a control circuit 25 configured to control the drive substrate 23.

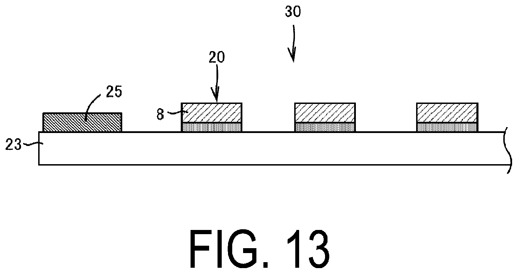

FIG. 13 is a schematic view illustrating another configuration of the electronic device according to the present embodiment. An electronic device 30 in FIG. 13 includes the semiconductor device 20 including at least the low defect portion EK, the drive substrate 23 on which the semiconductor device 20 is mounted, and the control circuit 25 configured to control the drive substrate 23.

Examples of the electronic device 30 include display devices, laser emitting devices (including a Fabry-Perot type and a surface emitting type), lighting devices, communication devices, information processing devices, sensing devices, and electrical power control devices.

### Example 1

### Overall Configuration

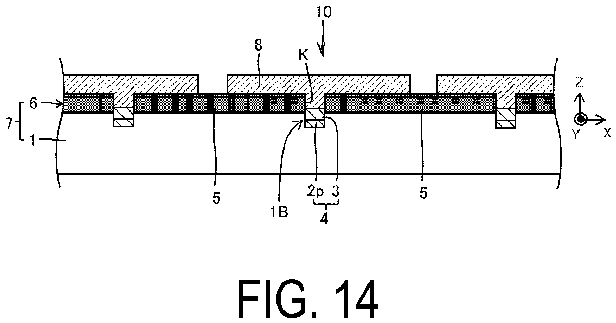

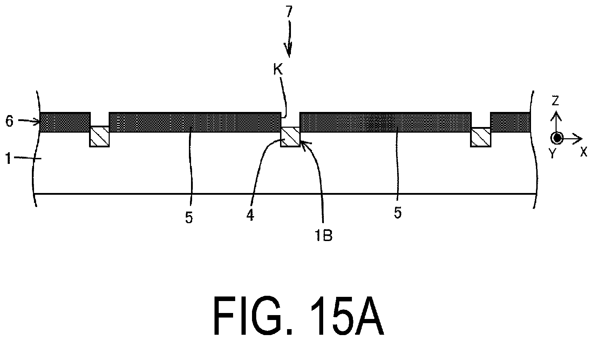

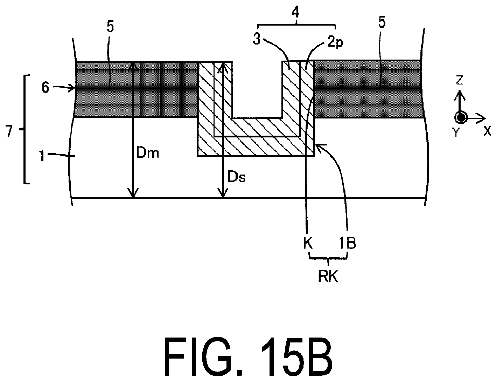

FIG. 14 is a cross-sectional view illustrating a configuration of the semiconductor substrate according to Example 1. FIG. 15A is a cross-sectional view illustrating a configuration of the template substrate according to Example 1. FIG. 15B is an enlarged view illustrating the configuration of the template substrate according to Example 1. As illustrated in FIG. 14, the semiconductor substrate 10 according to Example 1 includes the template substrate 7, and the semiconductor part 8 including a GaN-based semiconductor and disposed in contact with the seed portion 3 and the mask portion 5 of the template substrate 7. The laminate 4 is locally disposed to be aligned with the opening K in a plan view. The laminate 4 includes the buffer portion 2p in contact with the support substrate 1 and the seed portion 3 in contact with the semiconductor part 8. Since the laminate 4 is locally provided on the support substrate 1, the support substrate 1 is in contact with the mask portion 5.

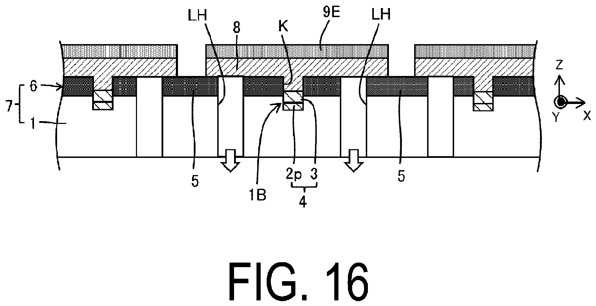

FIG. 16 is a cross-sectional view illustrating an application example of the template substrate. One of the advantages of the template substrate 7 is that, in a light emitting diode (LED) device having a back light extraction structure including an LED layer 9E as illustrated in FIG. 16, light loss from a side surface is reduced by reducing the thickness of the entire GaN-based semiconductor layer and light extraction efficiency is increased. A hole LH extending from the back surface of the support substrate 1 to the semiconductor part 8 can also be easily formed. As will be described below, by using a surface-processed film (for example, a nitride film of a Si substrate, an oxide film of a Si substrate, or the like) of the support substrate 1 as the mask portion 5, the flatness of the surface of the mask portion can be enhanced as compared with a case where the mask portion 5 is film-formed (for example, by a sputtering method or a plasma CVD method), light scattering when used as an LED can be suppressed, and the degree of adhesion between the (ELO) semiconductor part 8 and the mask portion 5 can be reduced. By reducing the degree of adhesion, the semiconductor part 8 can be easily peeled off.

The opening K of the mask pattern 6 and the laminate 4 each have a longitudinal shape in which the X direction is a width direction and the Y direction is a longitudinal direction. The support substrate 1 has a recessed portion 1B that opens upward, the opening K overlaps the recessed portion 1B in the plan view, and the laminate 4 (the buffer portion 2p and the seed portion 3) overlaps the recessed portion 1B and the opening K in the plan view. Thus, the function of the buffer portion 2p (for example, AlN film) as a meltback etching protective film is enhanced. This is because as a step difference is formed in the AlN film, a minute crack is more likely to occur in the AlN film due to stress concentration, and the GaN-based semiconductor on the AlN film and the support substrate (for example, Si substrate) are more likely to come into contact with each other to cause meltback etching (mutual melting). The recessed portion 1B has the Y direction as a longitudinal direction (see FIG. 1). The opening K and the recessed portion 1B are aligned with each other to form a communication hole RK. Since the laminate 4 is formed inside the communication hole RK, the laminate 4 (the buffer portion 2p and the seed portion 3) may have a recessed shape.

Since the seed portion 3 including the GaN-based semiconductor and used in the ELO method has a tensile stress with respect to the silicon substrate at room temperature, the local formation of the seed portion 3 can relax the stress and reduce the warp of the semiconductor substrate 10. Since cracks are less likely to occur than when a buffer such as an AlN film is formed on the entire surface, the buffer portion 2p can be made thicker and meltback etching resistance can be enhanced.

The template substrate 7 including the support substrate 1 and the mask pattern 6 has the seed portion 3 disposed locally in a layer above the support substrate 1 in the plan view, and a distance Ds between a lower surface of the support substrate 1 and an upper surface of the seed portion 3 is equal to or less than a distance Dm between the lower surface of the support substrate 1 and an upper surface of the mask portion 5.

### Support Substrate

A heterogeneous substrate having a lattice constant different from that of a GaN-based semiconductor may be used for the support substrate 1 (main substrate). Examples of the heterogeneous substrate include a single-crystal silicon (Si) substrate, a sapphire (Al₂O₃) substrate, and a silicon carbide (SiC) substrate. The plane orientation of the support substrate 1 is, for example, a (111) plane of the silicon substrate, a (0001) plane of the sapphire substrate, or a 6H-SiC (0001) plane of the SiC substrate. These are merely examples, and any support substrate and any plane orientation may be used as long as the semiconductor part 8 can be grown by the ELO method.

### Laminate

As the laminate 4, the buffer portion 2p and the seed portion 3 can be provided in order from the support substrate 1 side. The seed portion 3 is a growth starting point of the semiconductor part 8 and is joined to the semiconductor part 8. For the seed portion 3, a GaN-based semiconductor, aluminum nitride (AlN), silicon carbide (SiC), graphene, or the like can be used. The silicon carbide used for the seed portion 3 is preferably hexagonal system 6H-SiC or 4H-SiC. In Example 1, the seed portion 3 can be formed by a sputtering method, a pulse sputter deposition (PSD) method, or a laser ablation method.

The buffer portion 2p has a function of reducing the melting between the support substrate 1 and the seed portion 3 due to their contact with each other. For example, when a silicon substrate is used for the support substrate 1 and a GaN-based semiconductor is used for the seed portion 3, since the silicon substrate and the GaN-based semiconductor melt together, the melting is reduced by providing the buffer portion 2p between the silicon substrate and the GaN-based semiconductor. The buffer portion 2p may have at least one of the effect of enhancing the crystallinity of the seed portion 3 and the effect of relaxing internal stress of the seed portion 3.

For the buffer portion 2p, for example, a GaN-based semiconductor including Al, aluminum nitride (AlN), and silicon carbide (SiC) can be used. The silicon carbide used for the buffer portion 2p may be a hexagonal system (6H-SiC, 4H-SiC) or a cubic system (3C-SiC). The buffer portion 2p may include a strain relaxation layer. The strain relaxation layer has, for example, an AlGaN superlattice structure or a graded structure in which the Al composition of AlGaN is changed stepwise. The stress in the longitudinal direction of the semiconductor part 8 can be relaxed by the strain relaxation layer.

Examples of the laminate 4 include a configuration in which a silicon substrate is used as the support substrate 1, AlN is used as the buffer portion 2p (formed to a thickness of about 10 nm to about 5 µm by using, for example, an MOCVD device), and a GaN-based semiconductor is used as the seed portion 3, a configuration in which a silicon substrate is used as the support substrate 1, silicon carbide is used as the buffer portion 2p, and aluminum nitride is used for the seed portion 3, and a configuration in which a silicon substrate is used as the support substrate 1, a laminated film of silicon carbide and aluminum nitride is used as the buffer portion 2p, and a GaN-based semiconductors are used for the seed portion 3.

When using the support substrate 1 is unlikely to melt with the GaN-based semiconductor of the seed portion 3, a configuration with no buffer portion is also possible. That is, when the seed portion 3 and the support substrate 1 do not melt together, the buffer portion is not necessarily required, and a configuration in which the seed portion 3 is locally provided on the support substrate 1 is possible (will be described below). This allows to adopt a configuration in which a silicon substrate is used as the support substrate 1 and aluminum nitride is used for the local seed portion 3, a configuration in which a silicon substrate is used as the support substrate 1 and hexagonal silicon carbide is used for the local seed portion 3, a configuration in which a silicon carbide substrate is used as the support substrate 1 and a GaN-based semiconductor is used for the local seed portion 3, and a configuration in which a silicon carbide substrate is used as the support substrate 1 and hexagonal silicon carbide is used for the local seed portion 3.

### Mask Pattern

The mask pattern 6 includes the mask portion 5 and the opening K. The opening K may have a function of a growth start hole that exposes the seed portion 3 and starts the growth of the semiconductor part 8, and the mask portion 5 may have a function of a selective growth mask pattern for laterally growing the semiconductor part 8. The opening K of the mask pattern is a portion (non-formation portion) where the mask portion 5 is not formed, and may or may not be surrounded by the mask portion 5. An opening pattern of the mask pattern includes the opening K. Examples of the mask pattern 6 that can be used include a single-layer film including any one of a silicon oxide film (SiOx), a titanium nitride film (TiN or the like), a silicon nitride film (SiNx), a silicon oxynitride film (SiON), and a metal film having a high melting point (for example, 1000°C or higher), or a laminated film including at least two thereof. In Example 1, the mask pattern 6 can be formed by a thermal oxidation process of the support substrate 1, which is a silicon substrate, or by a nitriding process of the support substrate 1, which is a silicon substrate.

As the mask pattern 6, a laminated film in which a silicon oxide film and a silicon nitride film are formed in this order can be used. Since the semiconductor part 8 and the mask pattern 6 may react with each other and adhere to each other depending on film formation conditions, an upper layer film in direct contact with the semiconductor part 8 is preferably the silicon nitride film. In a process of locally forming the seed portion 3, a film on the support substrate 1 (lower layer film) may be removed, and the use of a silicon oxide film, from which the film on the support substrate 1 can be easily completely removed, as a lower layer film also has an effect of improving the yield of the process.

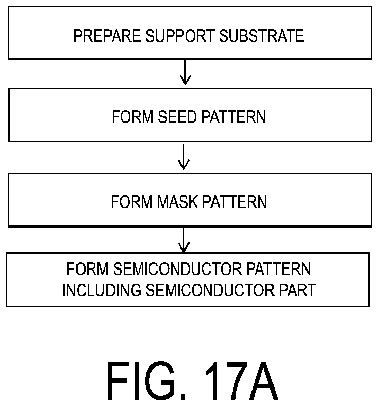

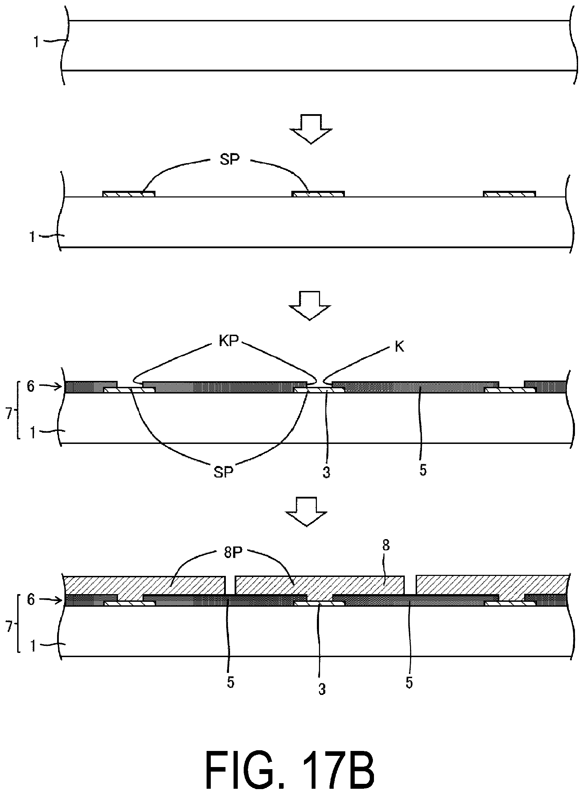

FIG. 17A is a flowchart illustrating a method for manufacturing the semiconductor substrate of Example 1. FIG. 17B is a cross-sectional view illustrating the method for manufacturing the semiconductor substrate of Example 1. The method for manufacturing the semiconductor substrate of Example 1 includes a step of preparing the support substrate 1, a step of forming the mask pattern 6 including the opening pattern KP above or within the support substrate 1, a step of forming the seed pattern SP having a smaller seed area than the mask area of the mask pattern 6 before or after the mask pattern 6 is formed, and a step of laterally growing the semiconductor pattern 8P (including, for example, a plurality of semiconductor parts 8) including a nitride semiconductor from above the seed pattern SP overlapping the opening pattern KP onto the mask portion 5 of the mask pattern 6. The opening pattern KP, the seed pattern SP, and the semiconductor pattern 8P may each have a stripe shape. The seed area of the seed pattern SP may be equal to or greater than the opening area of the opening pattern KP. The seed pattern SP may be formed at a lower temperature than for the semiconductor pattern 8P.

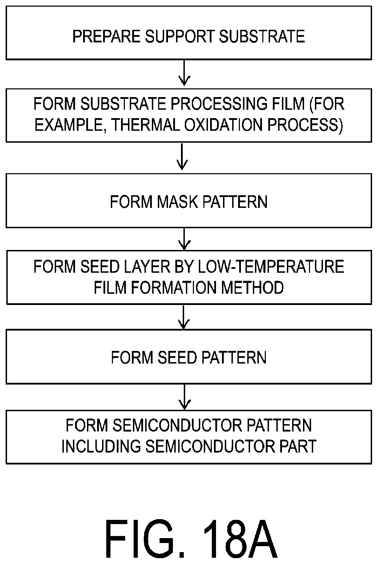

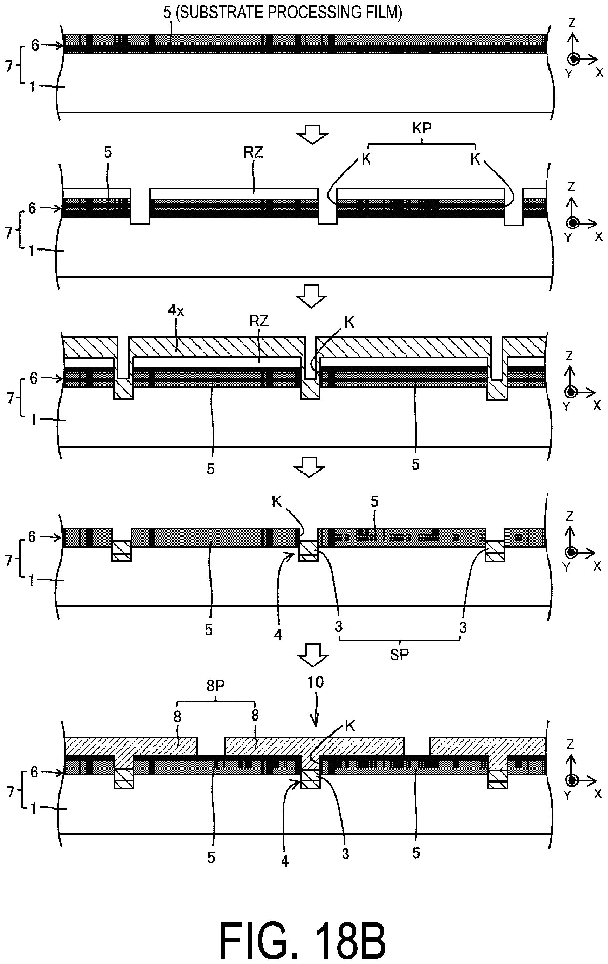

FIG. 18A is a flowchart illustrating a method for manufacturing the semiconductor substrate of Example 1. FIG. 18B is a cross-sectional view illustrating the method for manufacturing the semiconductor substrate of Example 1. The method for manufacturing the semiconductor substrate of Example 1 includes a step of preparing the support substrate 1 which is a single crystal silicon substrate, a step of thermally oxidizing or nitriding the support substrate 1 to form a substrate processing film (a thermal oxide film or a nitriding film) to be used as the mask portion 5 of the mask pattern 6, a step of patterning a resist RZ by photolithography, a step of forming the opening K in the mask pattern 6, a step of etching the substrate processing film from the opening K with an etchant such as hydrofluoric acid, a step of film-forming a laminated body 4x (an aluminum nitride layer and a gallium nitride layer) including a seed layer thereon at a low temperature (equal to or less than 500°) by using a sputtering method or the like while leaving the resist RZ, a step of removing the resist RZ (lift-off is performed to leave the seed portion 3 only in the opening K and form the seed pattern SP), and a step of forming the semiconductor pattern 8P (ELO) on the mask portion 5 from above the seed portion 3 overlapping the opening portion K.

When the laminated body 4x is formed while leaving the resist RZ, since the resist is burned in film formation at a high temperature exceeding 200°C, the laminated body 4x needs to be formed at a low temperature (exceeding 1000°C when MOCVD is used).

When a gallium nitride layer (GaN layer) to be the seed portion 3 is formed, a sputtering target containing gallium nitride as a main component (containing gallium in an amount of 25 atm% or more) and having an oxygen content of 5 atm% or less is used to perform sputtering at a sputtering gas pressure of less than 0.3 Pa during film formation.

As the sputtering method, DC sputtering, RF sputtering, AC sputtering, DC magnetron sputtering, electron cyclotron resonance (ECR) sputtering, RF magnetron sputtering, a pulse sputter deposition (PSD) method, a laser ablation method, or the like can be selected as appropriate.

In order to enhance the crystallinity of an entire film, the oxygen content of a sputtering target to be used is equal to or less than 5 atm%, is preferably equal to or less than 3 atm%, and is more preferably equal to or less than 1 atm%. The purity is also desirably as high as possible, and the content of metal impurities is preferably less than 0.1%, and more preferably less than 0.01%. When a GaN layer is formed by the sputtering method, effects such as surface flatness, improvement in the crystallinity of the GaN layer, and suppression of generation of surface hillocks (protruding portions) can be obtained by using a gallium nitride target with a low oxygen content.

The degree of vacuum in a film forming apparatus before film formation is preferably equal to or less than 3 × 10⁻⁵ Pa or less, and is more preferably equal to or less than 1 × 10⁻⁵ Pa or less. More preferably, the substrate is pretreated before film formation. By performing the pretreatment, an organic layer or unevenness on the surface of the substrate can be removed, thereby enabling epitaxial growth. Examples of the pretreatment include a reverse sputtering treatment, an acid treatment, and a UV treatment, and the reverse sputtering treatment is preferable from the viewpoint of avoiding reattachment of impurities or the like after the treatment. The reverse sputtering is a method in which atoms turned into plasma collide with the substrate side instead of a sputtering target side to clean the surface of the substrate. The substrate temperature during the film formation may be room temperature, but performing the film formation with the substrate being heated (for example, 400°C to 1000°C) can further improve the film quality.

The power density during discharge is preferably equal to or less than 5 W/cm², and is more preferably 1.5 W/cm² or less. The lower limit is preferably 0.1 W/cm ², and is more preferably 0.3 W/cm². The power density is obtained by dividing the power during discharge by an area of the sputtering target. When the power density is too high, since a raw material may be sputtered from the target in a clustered state, the power density can be set as appropriate.

As an example, as conditions for forming the GaN layer, an RF sputtering method is used and a gallium nitride target is used. At this time, the oxygen content of the gallium nitride target was 0.4 atom%. The film forming pressure was 0.1 Pa, and 20 sccm to 40 sccm of nitrogen was introduced. At this time, argon gas was not allowed to flow, but argon gas may be introduced to form a film. The discharge density was 125 W/cm², and the film-forming temperature was room temperature.

When a film is formed using the sputtering method, the laser ablation method, or the like described above, the film often has an internal stress as compared with a seed portion formed by an MOCVD device, causing a problem such as generation of a crack depending on a film thickness or film formation conditions. Therefore, the laminate 4 including the seed portion 3 is desirably locally formed on the support substrate (wafer).

A gallium nitride film formed by sputtering is also known to contain more oxygen than a gallium nitride film formed by MOCVD. For example, the concentration of oxygen contained in the gallium nitride film serving as the seed portion may be equal to or greater than 1 × 10¹⁹ /cm³, and in such a case, internal stress may increase (cause cracking). Therefore, when the seed portion (including a great amount of oxygen) formed by the sputtering method is used, the seed portion is preferably disposed to overlap not an entire surface of the support substrate but a part thereof in a plan view (that is, locally) in order to relax the internal stress. In addition to the seed portion, a buffer (a buffer portion, a buffer layer) made of AlN, GaN-based semiconductor, SiC, or the like may be formed by a sputtering method, a pulse sputter deposition (PSD) method, or a laser ablation method.

A plurality of openings K are periodically arranged in the a-axis direction (X direction) of the semiconductor part 8. The width of the opening K is set to about 0.1 µm to about 20 µm. As the width of each opening decreases, the number of threading dislocations propagating from each opening to the semiconductor part 8 decreases. In a post process, the semiconductor part 8 is easily peeled (separated) from the template substrate 7. An area of the low defect portion EK with few surface defects can be increased.

Since the silicon oxide film formed by thermal oxidation of the support substrate or the silicon nitride film formed by nitriding the support substrate has high film quality and is difficult to decompose and evaporate at a high temperature, an advantage is that defects of the semiconductor part 8 can be reduced. Since the substrate processing film such as a thermal oxide film has a compressive stress with respect to the support substrate 1, an effect of relaxing the tensile stress of the semiconductor part 8 is also exhibited. The thermal oxide film and the nitriding film are composed of one or more kinds of atoms (for example, Si) included in the support substrate 1 and oxygen atoms or nitrogen atoms. In Example 1, the mask pattern 6 can also be formed by a general plasma chemical vapor deposition (CVD) method.

### Film Formation of Semiconductor Part

In Example 1, the semiconductor part 8 was a GaN layer, and ELO film formation was performed on the above-described template substrate 7 by using the MOCVD device included in the semiconductor former 72 of FIG. 8. The following may be adopted as examples of the ELO film formation conditions, such as substrate temperature of 1120°C, growth pressure of 50 kPa, trimethylgallium (TMG) of 22 sccm, NH₃ of 15 slm, and V/III = 6000 (ratio of group V raw material supply amount to group III raw material supply amount).

In this case, the semiconductor part 8 was selectively grown on the seed portion 3 (GaN layer) of the laminate 4 and subsequently laterally grown on the mask portion 5. The lateral growth was stopped before the semiconductor parts laterally grown from both sides of the mask portion 5 are associated with each other.

A width Wm of the mask portion 5 was 50 µm, the width of the opening K was 5 µm, a lateral width of the semiconductor part 8 was 53 µm, a width (size in the X direction) of the low defect portion EK was 24 µm, and a layer thickness of the semiconductor part 8 was 5 µm. The aspect ratio of the semiconductor part 8 is 10.6 (53 µm/5 µm) and a very high aspect ratio was achieved.

In the lateral growth of the semiconductor part 8, interaction between the semiconductor part 8 and the mask portion 5 is preferably reduced, and a state in which the semiconductor part 8 and the mask portion 5 are in contact with each other by Van der Waals force is preferable.

A method for increasing the lateral film-formation rate is as follows. First, a longitudinal growth layer that grows in the Z direction (c-axis direction) is formed on the laminate 4, and then a lateral growth layer that grows in the X direction (a-axis direction) is formed thereon. In this case, by setting the thickness of the longitudinal growth layer to be equal to or less than 10 µm, 5 µm, 3 µm, or 1 µm, the thickness of the lateral growth layer can be kept low and the lateral film-formation rate can be increased.

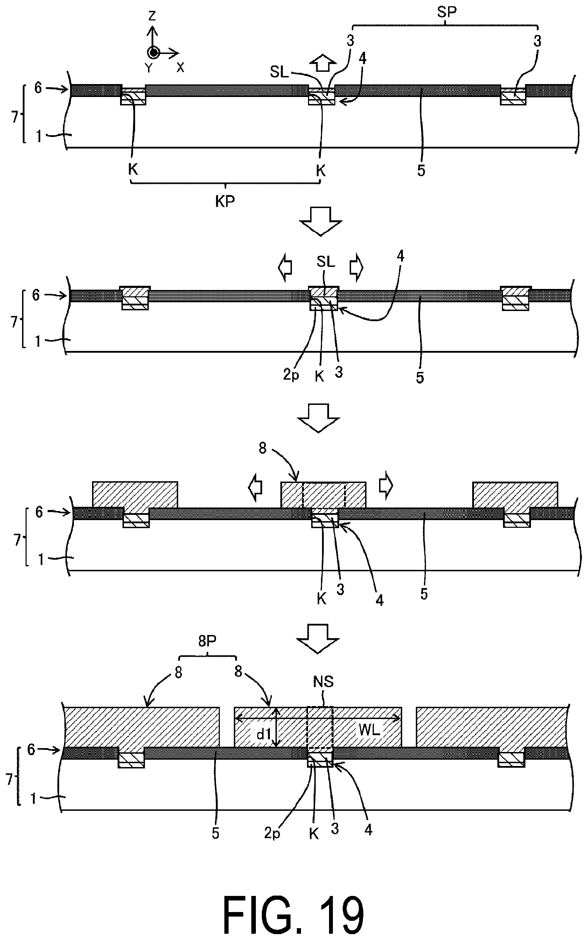

FIG. 19 is a cross-sectional view illustrating an example of lateral growth of the semiconductor part. As illustrated in FIG. 19, an initial growth layer (longitudinal growth layer) SL is desirably formed on the laminate 4, and then the semiconductor part 8 is desirably grown laterally from the initial growth layer SL. The initial growth layer SL serves as a start point of the lateral growth of the semiconductor part 8. The semiconductor part 8 can be controlled to grow in the Z direction (c-axis direction) or in the X direction (a-axis direction) by appropriately controlling the ELO film formation conditions.

In the film formation of the semiconductor portion 8, a method can be used to stop the film formation of the initial growth layer SL at a timing immediately before an edge of the initial growth layer SL rides on the upper surface of the mask portion 5 (at a stage of being in contact with the upper end of a side surface of the mask portion 5) or immediately after the edge of the initial growth layer SL rides on the upper surface of the mask portion 5 (that is, at this timing, the ELO film formation condition is switched from the c-axis direction film-formation condition to the a-axis direction film-formation condition). By so doing, since the lateral film formation is carried out from a state where the initial growth layer SL slightly protrudes from the mask portion 5, a material consumed for the growth in the thickness direction can be reduced, and a first semiconductor part 8F (a plurality of ridges 8U) can be grown laterally at a high speed. The initial growth layer SL can be formed with a thickness of, for example, 50 nm to 5.0 µm (for example, 80 nm to 2 µm). The thickness of the mask portion 5 and the thickness of the initial growth layer SL may be equal to or less than 500 nm.

By laterally growing the semiconductor part 8 after the initial growth layer SL (part of dislocation inheritance portion NS) is formed as illustrated in FIG. 19, the number of non-threading dislocations inside the low defect portion EK can be increased (threading dislocation density on the surface of the low defect portion EK can be reduced). The distribution of impurity concentration (for example, silicon or oxygen) inside the low defect portion EK can be controlled. When the method of FIG. 19 is used, the aspect ratio (ratio of the size in the X direction to the thickness = WL/d1) of the semiconductor part 8 is dramatically increased to be equal to or greater than 3.5, 5.0, 6.0, 8.0, 10, 15, 20, 30, or 50. When the method of FIG. 19 is used, the ratio of the width WL of the semiconductor part 8 to the opening width can be set to be equal to or greater than 3.5, 5.0, 6.0, 8.0, 10, 15, 20, 30, or 50, and the ratio of the low defect portion EK increases. The semiconductor part 8 illustrated in FIG. 19 can be a nitride semiconductor crystal (for example, a GaN crystal, an AlGaN crystal, an InGaN crystal, or an InAlGaN crystal).

A film-forming temperature of the semiconductor part 8 is preferably equal to or less than 1150°C, rather than a high temperature exceeding 1200°C. The semiconductor part 8 can be formed even at a low temperature below 1000°C, which is more preferable from the viewpoint of reducing the interaction. It can be seen that in such low-temperature film formation, when trimethyl gallium (TMG) is used as a gallium raw material, the raw material is not sufficiently decomposed, and gallium atoms and carbon atoms are simultaneously taken into the semiconductor part 8 in greater quantities than usual. The reason for this may be as follows: in the ELO method, since the film formation in the a-axis direction is fast and the film formation in the c-axis direction is slow, the above atoms are taken in great quantities during the c-plane film formation.

It has been found that the carbon taken into the semiconductor part 8 reduces a reaction with the mask portion 5, and reduces adhesion or the like between the mask portion 5 and the semiconductor part 8. Therefore, in the low-temperature film formation of the semiconductor part 8, the supply amount of ammonia is reduced and the film formation is performed at a substantially low V/III (< 1000), thereby making it possible to take carbon elements in the raw material or a chamber atmosphere into the semiconductor part 8 and to reduce a reaction with the mask portion 5. In this case, the semiconductor part 8 includes carbon.

In the low-temperature film formation at a temperature below 1000°C, triethylgallium (TEG) is preferably used as a gallium raw material gas. Since an organic raw material is efficiently decomposed at a low temperature with TEG as compared with TMG, the lateral film-formation rate can be increased.

### Isolation and Separation of Element Portion

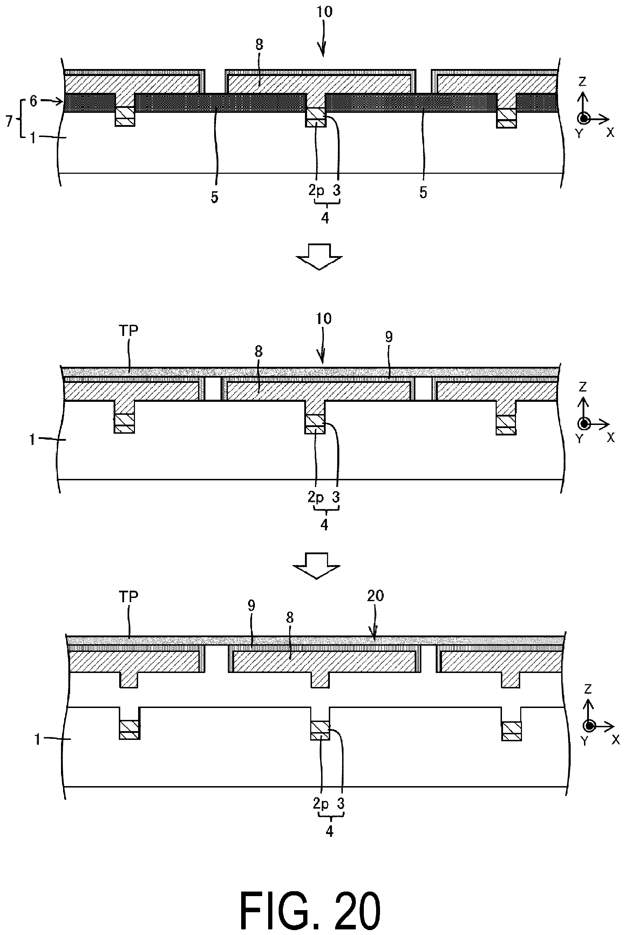

FIG. 20 is a cross-sectional view illustrating a step of separating an element portion in Example 1. In Example 1, as illustrated in FIG. 20, the semiconductor substrate 10 may be immersed in an etchant ET to dissolve the mask pattern 6, an adhesive tape TP (for example, an adhesive dicing tape used for dicing a semiconductor wafer) may be attached to the surface of the semiconductor part 8, and then the temperature of the semiconductor substrate 10 with the adhesive tape attached thereto as is may be lowered to a low temperature by using a Peltier element (not illustrated). At this time, the adhesive tape generally having a greater thermal expansion coefficient than a semiconductor contracts considerably and stress is applied to the semiconductor part 8. Since the semiconductor part 8 is bonded only to the laminate 4 of the template substrate 7 and the mask portion 5 has been removed, the stress from the adhesive tape is effectively applied to a bonding portion with the laminate 4 (of the template substrate 7), so that the bonding portion can be mechanically cleaved or broken. That is, etching is not needed for the removal of the bonding portion.

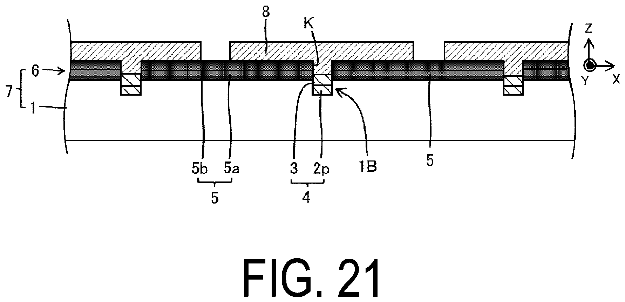

FIGs. 21 to 24 are cross-sectional views illustrating other configurations of the semiconductor substrate of Example 1. In Example 1, as illustrated in FIG. 21, the mask portion 5 may have a laminated structure. For example, the mask portion 5 can be configured to include a silicon oxide film 5a located on the support substrate side (lower layer side) and a silicon nitride film 5b located on an upper layer side and in contact with the semiconductor part 8.

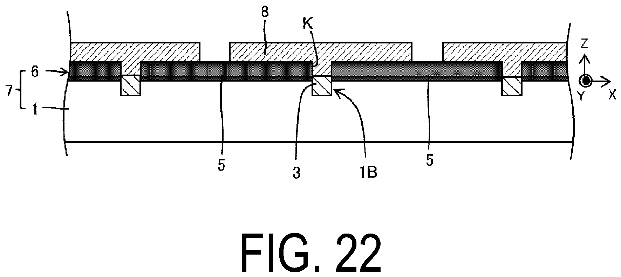

In Example 1, as illustrated in FIG. 22, the seed portion 3 may be provided to overlap a recessed portion 1B of the support substrate 1 in a plan view and to be in contact with the support substrate 1. In this case, for example, a silicon substrate may be used as the support substrate 1 and aluminum nitride may be used for the local seed portion 3, or a silicon substrate may be used as the support substrate 1 and hexagonal silicon carbide may be used for the local seed portion 3.

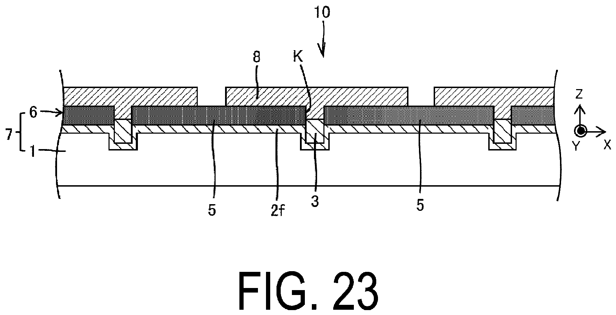

In Example 1, as illustrated in FIG. 23, a buffer layer 2f may be formed on the entire upper surface of the support substrate 1 (including the recessed portion 1B), and the seed portion 3 may be locally disposed on the buffer layer 2f so as to overlap the recessed portion 1B in the plan view. In this case, AlN or SiC can be used as the buffer layer 2f, and GaN can be used for the seed portion 3.

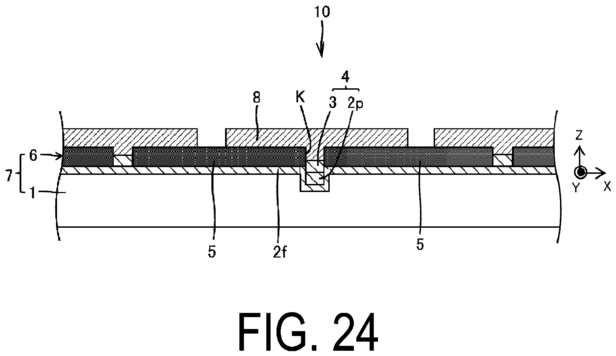

In Example 1, as illustrated in FIG. 24, the buffer layer 2f may be formed on the entire upper surface (including the recessed portion 1B) of the support substrate 1, and the laminate 4 including the buffer portion 2p and the seed portion 3 may be locally disposed on the buffer layer 2f so as to overlap the recessed portion 1B in the plan view. In this case, for example, SiC can be used as the buffer layer 2f, a strain relaxation layer can be provided in the buffer portion 2p, and GaN can be used for the seed portion 3.

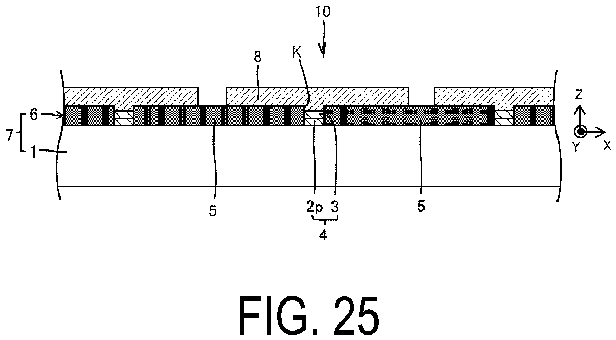

FIGs. 25 to 27 are cross-sectional views illustrating still other configurations of the semiconductor substrate of Example 1. In FIG. 14, the recessed portion 1B is formed on the surface of the support substrate 1 and the laminate 4 is formed in the recessed portion 1B; however, the present disclosure is not limited thereto. As illustrated in FIG. 25, the laminate 4 (the buffer portion 2p and the seed portion 3) may be provided in the opening K without forming the recessed portion 1B on the surface of the support substrate 1 (with the surface of the support substrate 1 as a flat surface).

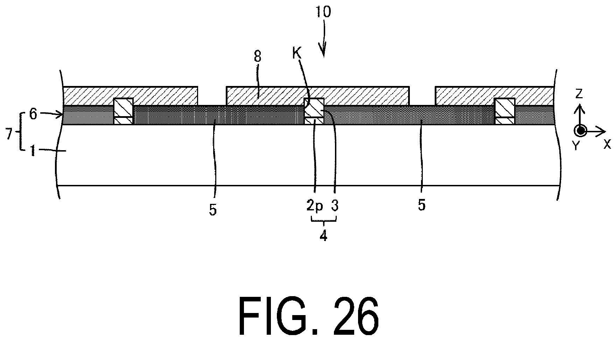

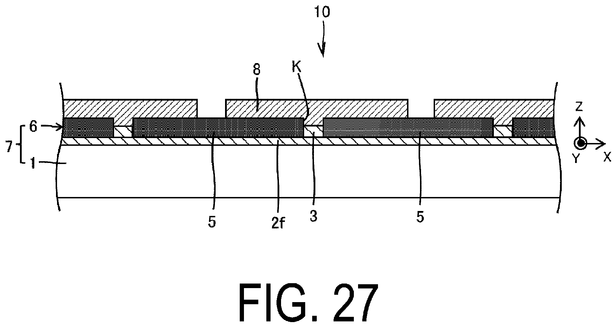

As illustrated in FIG. 26, the laminate 4 may be provided so that a part thereof protrudes upward from the opening K without forming the recessed portion 1B on the surface of the support substrate 1. As illustrated in FIG. 27, the buffer layer 2f may be formed on the entire upper surface of the support substrate 1 (entire wafer surface), and the seed portion 3 may be locally disposed on the buffer layer 2f. The buffer layer 2f is formed on the entire upper surface of the support substrate 1, and the seed portion 3 is locally disposed, so that stresses can be relaxed. The buffer layer 2f is formed on the entire surface, making it possible to suppress deterioration of the mask portion 5 caused by reaction between the mask portion 5 and the support substrate 1 during film formation due to the film-forming temperature of MOCVD.

Specific examples of FIG. 27 include a configuration in which a silicon substrate is used as the support substrate 1, AlN is used as the buffer layer 2f, and a GaN-based semiconductor is used as the seed portion 3, a configuration in which a silicon substrate as the support substrate 1, silicon carbide is used as the buffer layer 2f, and aluminum nitride is used for the seed portion 3, and a configuration in which a silicon substrate is used as the support substrate 1, a laminated film of silicon carbide and aluminum nitride is used as the buffer layer 2f, and a GaN-based semiconductor is used for the seed portion 3.

### Example 2

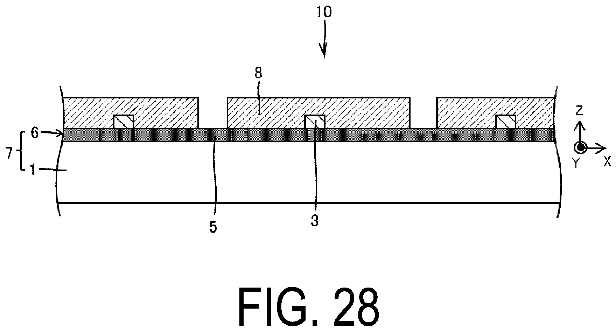

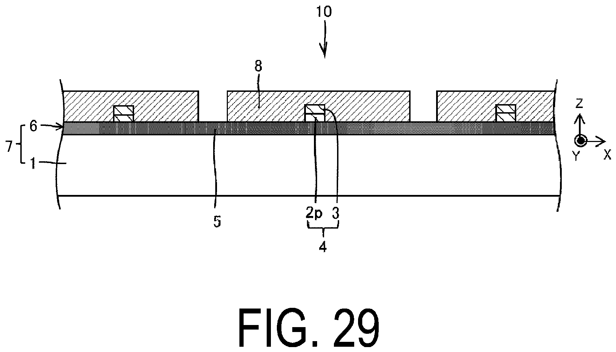

FIGs. 28 and 29 are cross-sectional views illustrating configurations of the semiconductor substrate of Example 2. In Example 1, the laminate 4 is locally formed to overlap the opening K; however, the present disclosure is not limited thereto. As illustrated in FIGs. 28 and 29, the mask portion 5 can be a thermal oxide film or a nitriding film of the support substrate, and the seed portion 3 or the laminate 4 can also be provided on the mask portion 5. That is, the mask pattern 6 has no opening overlapping the semiconductor part 8 in a plan view. By so doing, the step of patterning the mask pattern 6 can be omitted. In this case, as illustrated in FIG. 28, the seed portion 3 (for example, GaN-based semiconductor) may also be provided on the mask pattern 6, or as illustrated in FIG. 29, the seed portion 3 (for example, GaN-based semiconductor or the like) may also be provided on the mask pattern 6 via the buffer portion 2p (for example, AlN or the like). As a method for forming the seed portion 3 or the laminate 4, for example, a direct bonding method can be applied in which a bonding surface is activated by Ar plasma or the like in a vacuum to perform pressure bonding.

### Example 3

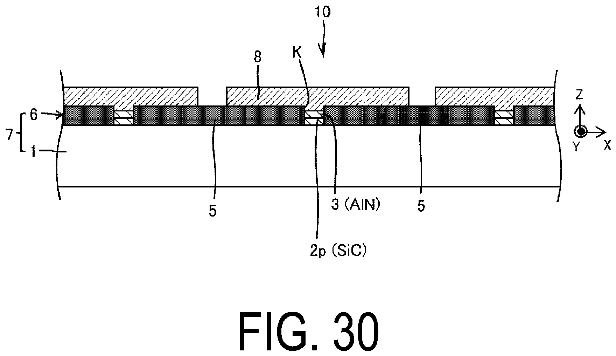

FIG. 30 is a cross-sectional view illustrating a configuration of Example 3. In FIG. 30, a silicon substrate is used as the support substrate 1, SiC is used for the local buffer portion 2p, and AlN is used for the seed portion 3. SiC may have a 3C, 4H, or 6H crystalline structure. SiC, which is more stable at a higher temperature than AlN, is preferably used for the buffer portion 2p because meltback etching (melting between the support substrate 1 and the semiconductor part 8) can be suppressed as compared with AlN. Since the difference in thermal expansion coefficient from the silicon substrate is less than that of AlN, warp during growth of the semiconductor part 8 (GaN layer) is further suppressed, and in-plane uniformity during growth of the semiconductor part 8 (GaN layer) is enhanced.

### Example 4

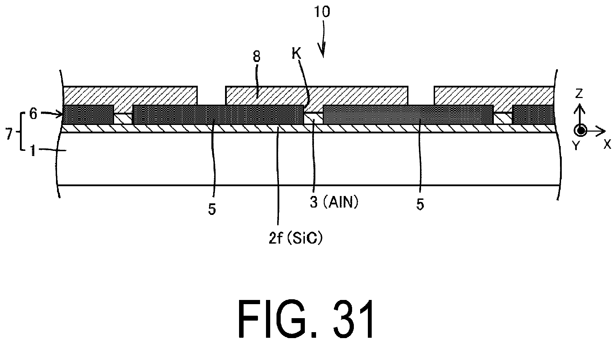

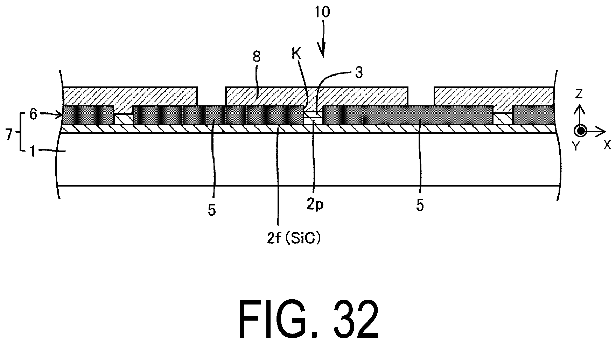

FIGs. 31 and 32 are cross-sectional views illustrating configurations of Example 4. In FIG. 31, a silicon substrate is used as the support substrate 1, SiC is used for the buffer layer 2f, and AlN is used for the local seed portion 3. SiC may have a 3C, 4H, or 6H crystalline structure. The buffer layer 2f is formed substantially on the entire upper surface of the support substrate 1. Since the buffer layer 2f is formed on the entire surface, a reaction between the mask portion 5 and the support substrate 1 can be suppressed. Even when the mask portion 5 is set to be thin, the buffer layer 2f is preferably present on the entire surface because a reaction between the support substrate 1 and the semiconductor part 8 via the mask portion 5 or an interface between the mask portion 5 and the seed portion 3 can be suppressed. For example, when the mask portion 5 has a thickness equal to or less than 20 nm, the support substrate 1 and the semiconductor part 8 may react with each other to cause a great number of defects in the semiconductor part 8 on the mask portion 5, but such a phenomenon can be avoided. In Example 4, as illustrated in FIG. 32, the seed portion 3 (for example, GaN) may be provided on the buffer layer 2f (silicon carbide), which is formed on the entire upper surface of the support substrate 1, via the local buffer portion 2p (for example, AlN).

### Example 5

In Examples 1 to 4, the semiconductor part 8 is a GaN layer; however, the present disclosure is not limited thereto. As the semiconductor part 8 of Examples 1 to 4, an InGaN layer, which is a GaN-based semiconductor part, can also be formed. The lateral film formation of the InGaN layer is carried out at a low temperature below 1000°C, for example. This is because the vapor pressure of indium increases at a high temperature and indium is not effectively taken into the film. When the film-forming temperature is low, an effect is exhibited in which the interaction between the mask portion 5 and the InGaN layer is reduced. The InGaN layer has an effect of exhibiting lower reactivity with the mask portion 5 than the GaN layer. When indium is taken into the InGaN layer at an In composition level of 1% or more, the reactivity with the mask portion 5 is further lowered, which is desirable. As the gallium raw material gas, triethylgallium (TEG) is preferably used.

### Example 6

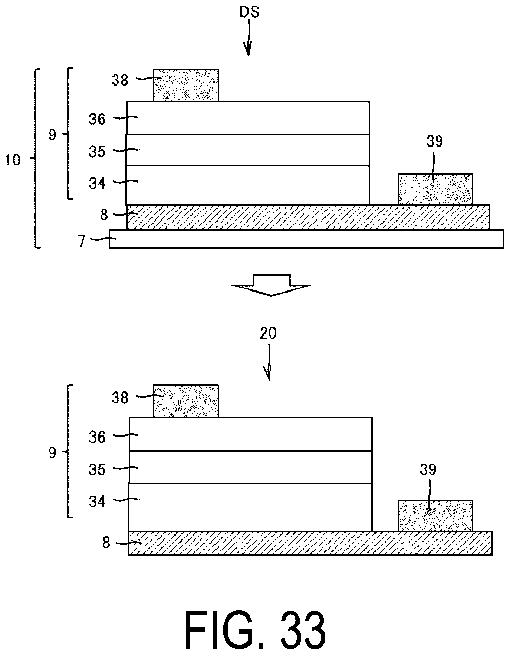

FIG. 33 is a schematic cross-sectional view illustrating a configuration of Example 6. In Example 6, the functional layer 9 constituting an LED is film-formed on the semiconductor part 8. The semiconductor part 8 is of n-type doped with silicon or the like, for example. The functional layer 9 includes an active layer 34, an electron blocking layer 35, and a GaN-based p-type semiconductor part 36 in order from a lower layer side. The active layer 34 is a multi-quantum well (MQW), and includes an InGaN layer and a GaN layer. The electron blocking layer 35 is, for example, an AlGaN layer. The GaN-based p-type semiconductor part 36 is, for example, a GaN layer. An anode 38 is disposed to be in contact with the GaN-based p-type semiconductor part 36, and a cathode 39 is disposed to be in contact with the semiconductor part 8. The semiconductor device 20 (including a GaN-based crystal body) can be obtained by separating the conductor portion 8 and the functional layer 9 from the template substrate 7.

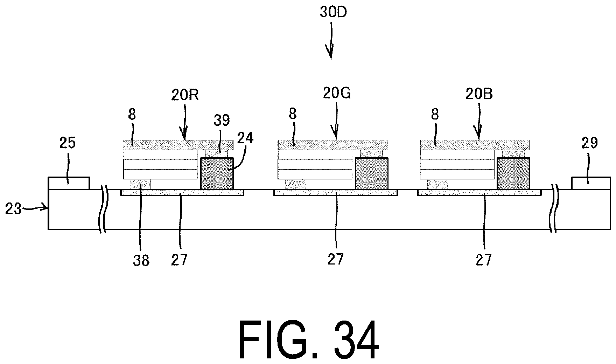

FIG. 34 is a cross-sectional view illustrating an application example to an electronic device of Example 4. According to Example 6, a red micro LED 20R, a green micro LED 20G, and a blue micro LED 20B can be obtained, and a micro LED display 30D (electronic device) can be constituted by mounting these LEDs on the drive substrate (TFT substrate) 23. As an example, the red micro LED 20R, the green micro LED 20G, and the blue micro LED 20B are mounted on a plurality of pixel circuits 27 of the drive substrate 23 via a conductive resin 24 (for example, an anisotropic conductive resin) or the like, and then the control circuit 25, a driver circuit 29, and the like are mounted on the drive substrate 23. The drive substrate 23 may include a part of the driver circuit 29.

### Example 7

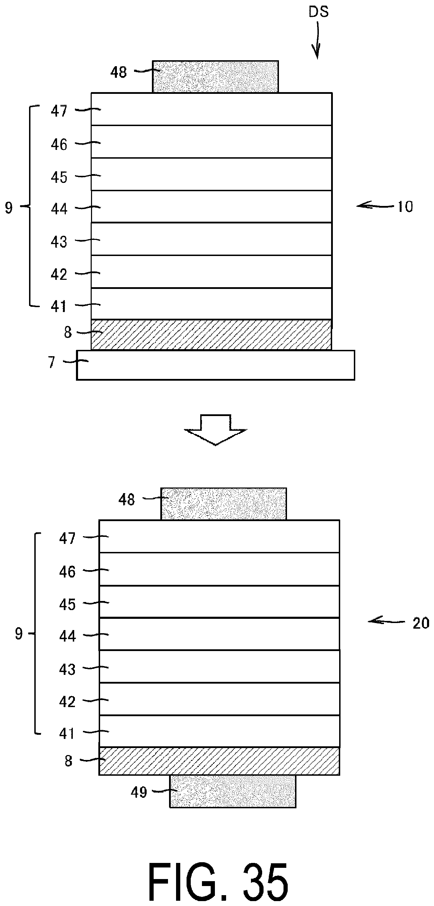

FIG. 35 is a schematic cross-sectional view illustrating a configuration of Example 7. In Example 7, the functional layer 9 constituting a semiconductor laser is film-formed on the semiconductor part 8. The functional layer 9 includes an n-type light cladding layer 41, an n-type light guide layer 42, an active layer 43, an electron blocking layer 44, a p-type light guide layer 45, a p-type light cladding layer 46, and a GaN-based p-type semiconductor part 47 in order from a lower layer side. For each of the guide layers 42 and 45, an InGaN layer can be used. A GaN layer or an AlGaN layer can be used for each of the cladding layers 41 and 46. An anode 48 is disposed to be in contact with the GaN-based p-type semiconductor part 47, and a cathode 49 is disposed to be in contact with the semiconductor part 8. By separating the semiconductor part 8 and the functional layer 9 from the template substrate 7, the semiconductor device 20 can be obtained.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Support substrate
1B Recessed portion
2p Buffer portion
2f Buffer layer
3 Seed portion
4 Laminate
5 Mask portion
6 Mask pattern
7 Template substrate
8 (ELO) Semiconductor part
9 Functional layer
10 Semiconductor substrate
20 Semiconductor device
30 Electronic device
K Opening

## Claims

1. A semiconductor substrate comprising:
a support substrate;
a mask pattern located in a layer above the support substrate and comprising a mask portion;
a seed portion located in a layer locally above the support substrate in a plan view; and
a semiconductor part including a GaN-based semiconductor and disposed in a layer above the mask pattern in a manner that the semiconductor part is in contact with the seed portion.

2. The semiconductor substrate according to claim 1, wherein
the mask pattern comprises an opening, and
the seed portion is locally disposed to overlap the opening in the plan view.

3. The semiconductor substrate according to claim 2, wherein
the opening has a longitudinal shape in which a first direction is a width direction and a second direction is a longitudinal direction, and
the seed portion has a longitudinal shape.

4. The semiconductor substrate according to claim 3, wherein
the support substrate comprises a recessed portion that opens upward,
the opening overlaps the recessed portion in the plan view, and
the seed portion overlaps the recessed portion and the opening in the plan view.

5. The semiconductor substrate according to claim 4, wherein
the seed portion has a recessed shape in a cross-sectional view.

6. The semiconductor substrate according to any one of claims 2 to 5, wherein
a distance between a lower surface of the support substrate and an upper surface of the seed portion is equal to or less than a distance between the lower surface of the support substrate and an upper surface of the mask portion.

7. The semiconductor substrate according to any one of claims 2 to 5, wherein
a distance between a lower surface of the support substrate and an upper surface of the seed portion is greater than a distance between the lower surface of the support substrate and an upper surface of the mask portion.

8. The semiconductor substrate according to claim 4, wherein
the recessed portion has a shape in which the second direction is the longitudinal direction.

9. The semiconductor substrate according to claim 1, wherein
the mask pattern has no opening overlapping the semiconductor part in the plan view.

10. The semiconductor substrate according to any one of claims 1 to 9, wherein
a buffer portion locally located in the plan view is provided between the support substrate and the seed portion.

11. The semiconductor substrate according to claim 1, further comprising:
a buffer layer located in a layer below the seed portion, wherein
the buffer layer is in contact with an upper surface of the support substrate.

12. The semiconductor substrate according to claim 11, wherein
the buffer layer comprises SiC and/or AlN.

13. The semiconductor substrate according to any one of claims 1 to 12, wherein
the mask portion comprises a thermal oxide film or a nitride film composed of one or more kinds of atoms included in the support substrate and oxygen atoms or nitrogen atoms.

14. The semiconductor substrate according to any one of claims 1 to 13, wherein
the mask portion comprises a laminated structure comprising a silicon nitride film and/or a silicon oxide film.

15. The semiconductor substrate according to any one of claims 1 to 14, wherein
the semiconductor part comprises an edge located between a center of the mask portion and the seed portion in the plan view.

16. The semiconductor substrate according to any one of claims 1 to 15, wherein
the seed portion comprises a GaN-based semiconductor, and
an oxygen content of the seed portion is greater than an oxygen content of the semiconductor part.

17. The semiconductor substrate according to claim 2, wherein
the seed portion and the opening are aligned with each other in the plan view.

18. A semiconductor device comprising:
the semiconductor part according to any one of claims 1 to 17.

19. An electronic device comprising:
the semiconductor device according to claim 18.

20. A template substrate comprising a support substrate, and a mask pattern located in a layer above the support substrate and comprising a mask portion and an opening, the template substrate comprising:
a seed portion disposed in a layer locally above the support substrate in a plan view, wherein
a distance between a lower surface of the support substrate and an upper surface of the seed portion is equal to or less than a distance between the lower surface of the support substrate and an upper surface of the mask portion.

21. A method for manufacturing a semiconductor substrate, the method comprising:
preparing a support substrate;
forming a mask pattern comprising an opening pattern above or within the support substrate;
forming a seed pattern comprising a seed area smaller than a mask area of the mask pattern before or after the mask pattern is formed; and
laterally growing a semiconductor pattern comprising a nitride semiconductor from above the seed pattern overlapping the opening pattern onto a mask portion of the mask pattern.

22. The method for manufacturing the semiconductor substrate according to claim 21, wherein
the seed pattern is formed using a sputtering method, a pulse sputter deposition (PSD) method, or a laser ablation method.

23. The method for manufacturing the semiconductor substrate according to claim 21, wherein
the opening pattern, the seed pattern, and the semiconductor pattern each have a stripe shape.

24. The method for manufacturing the semiconductor substrate according to claim 21, wherein
the mask pattern is formed using a thermal oxide film and or a nitride film obtained by performing a thermal oxidation process or a nitriding process on an upper surface of the support substrate.

25. The method for manufacturing the semiconductor substrate according to claim 21, wherein
the seed area is equal to or larger than an opening area of the opening pattern.

26. An apparatus for manufacturing a semiconductor substrate, the apparatus performing each of processes according to claim 21.
